# EUROPEAN PATENT APPLICATION

(11) **EP 4 632 683 A1**
(43) Date of publication of application: **15.10.2025**
(21) Application number: 25169883.3
(22) Date of filing: 10.04.2025
(51) Int. Cl.: G06T 19/20

(54) **METHODS FOR REMOVING DAMAGE WITHIN A FINITE ELEMENT MODEL OF A COMPONENT**

(30) Priority: 11.04.2024 US 202418632725
(71) Applicant: RTX Corporation, Farmington, CT 06032 (US)
(72) Inventor: VANDENBOSCH, Mason, Mason, 48854 (US); RICHARD, Ryan Robert, Windsor, 80550 (US); PUBINS, Tanner, Peoria, 85383 (US)
(74) Representative: Dehns

(57) **Abstract**

A component or region of an integrally bladed rotor (IBR) includes damage or a defect within a region on the blade of the rotor. A digital representation of the component is generated using an inspection system. The region is identified within the digital representation of the component. Data regarding the scanned IBR is aligned. The aligned data is used in a morphing process with a finite element model of the component that excludes the identified region. Additional operations are performed to morph the data within the identified region that removes the damage or defect from the finite element model.

## Description

### Field of the Invention

The disclosed embodiments relate to methods for removing damage of a component shown in a finite element model using morphing. More particularly, the disclosed embodiments related to executing a morphing process to remove damage to a component shown by a region of the finite element model.

### Description of the Related Art

Components used in the field exhibit damage when inspected. During inspection, the physical component is scanned into a digital finite element model to be analyzed. Existing inspection systems may virtually remove the damage of the scanned component so that the model may be subjected to a finite element analysis prior to removing damage from the physical component. Morphing is used to remove the damage virtually in some inspection systems.

One issue with morphing techniques for finite element models is shifting finite element node locations. This issue leads to an undesirable outcome when damage exists, showing discontinuities in the elements. An improved process is desired to use existing morphing techniques to remove damage characterized by the finite element model of the component.

### Summary of the Invention

According to a first aspect of the invention, there is provided a method which includes generating a digital representation of a component. The digital representation is based on geometrical dimensions of the component. The method also includes identifying at least one region of a plurality of regions within the digital representation of the component as showing damage to the component. The at least one region includes a boundary. The method also includes executing a morphing process within the plurality of regions of the digital representation. The method also includes applying a displacement field on the plurality of regions. The method also includes generating an output file having the damage removed within the at least one region of the digital representation.

According to a second aspect of the invention, there is provided a method which includes generating a digital representation of a blade of a bladed rotor having damage. The digital representation is based on geometrical dimensions of the component. The method also includes marking a boundary around the damage to the blade within the digital representation. The method also includes identifying a region based on the boundary within the digital representation of the blade showing the damage. The method also includes interpolating based on a node location within the boundary of the region. The method also includes executing a morphing process within the plurality of regions of the digital representation. The method also includes applying a displacement field on the plurality of regions. The method also includes generating a new digital representation of the blade having the damage removed.

According to a third aspect of the invention, there is provided an article of manufacture including a tangible, non-transitory computer-readable storage medium having instructions stored thereon is disclosed. The instructions, in response to execution by a processor, configures the processor to perform operations including generating a digital representation of a component. The digital representation is based on geometrical dimensions of the component. The operations also include identifying at least one region of a plurality of regions within the digital representation of the component as showing damage to the component. The at least one region includes a boundary. The operations also include executing a morphing process within the plurality of regions of the digital representation. The operations also include applying a displacement field on the plurality of regions. The operations also include generating an output file having the damage removed within the at least one region of the digital representation.

These, as well as other embodiments, aspects, advantages, and alternatives, will become apparent to those of ordinary skill in the art by reading the following detailed description, with reference where appropriate to the accompanying drawings. Further, this summary and other descriptions and figures provided herein are intended to illustrate embodiments by way of example only and, as such, numerous variations are possible. For instance, structural elements and process steps may be rearranged, combined, distributed, eliminated, or otherwise changed, while remaining with the scope of the invention as defined by the appended claims.

### Brief Description of the Drawings

Implementations of the inventive concepts disclosed herein may be better understood when consideration is given to the following non-limiting detailed description thereof. Such description makes reference to the included, non-limiting, drawings, which are not necessarily to scale, and which some features may be exaggerated and some features may be omitted or may be represented schematically in the interest of clarity. Like reference numerals in the drawings may represent and refer to the same or similar element, feature, or function. In the drawings:
Figure 1A illustrates a cross-sectional view of a gas-turbine engine;
Figure 1B illustrates a cross-sectional view of a high pressure compressor;
Figure 2 illustrates a front view of an integrally bladed rotor;
Figure 3 illustrates a damaged portion of an integrally bladed rotor;
Figure 4 illustrates a perspective view of an inspection system analyzing an integrally bladed rotor;
Figure 5 illustrates a block diagram of a control system for the inspection system;
Figure 6 illustrates a flowchart for removing damage detected on a scan of an integrally bladed rotor from an output file for a model;
Figure 7 illustrates a block diagram of the identification of damage regions in a scan file;
Figure 8 illustrates a block diagram of the alignment process;
Figure 9 illustrates an example of an aligned output; and
Figure 10 illustrates nodes within a region having a defect and nodes outside the region within a finite element model.

### Detailed Description of the Preferred Embodiments

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of the embodiments of the inventive concepts, numerous specific details are set forth in order to provide a more thorough understanding of the inventive concepts. It will be apparent to one skilled in the art, however, having the benefit of the instant disclosure that the inventive concepts disclosed herein may be practiced without these specific details.

As used herein, a letter following a reference numeral is intended to reference an embodiment of the feature or element that may be similar, but not necessarily identical, to a previously described element or feature bearing the same reference numeral, such as 1, 1a, or 1b. Such shorthand notations are used for purposes of convenience only, and should not be construed to limit the inventive concepts disclosed herein in any way unless expressly stated to the contrary.

Moreover, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

The inventive concepts may be described with reference to flowchart illustrations and/or block diagrams of methods, apparatus (systems) and computer program products according to embodiments of the invention. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

The flowchart and block diagrams in the figures illustrate the architecture, functionality, and operation of possible implementations of systems, methods and computer program products according to various embodiments of the present invention. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams or flowchart illustration, and combinations of blocks in the block diagrams or flowchart illustration, can be implemented by special purpose hardware-based systems that perform the specified functions or acts, or combinations of special purpose hardware and computer instructions.

Inventive concepts may be implemented as a computer process, a computing system or as an article of manufacture such as a computer program product of computer readable media. The computer program product may be a computer storage medium readable by a computer system and encoding computer program instructions for executing a computer process. When accessed, the instructions cause a processor to enable other components to perform the functions disclosed below.

As used herein, "aft" refers to the direction associated with the tail, or the back end, of an aircraft, or to the direction of exhaust of the gas turbine. As used here, "forward" refers to the direction associated with the nose, or front end, of the aircraft, or to the direction of flight or motion.

The disclosed methodology may smooth regions of a finite element (FE) model where damage exists on the corresponding component. This feature may be accomplished by specifying the regions where damage exists as "interpolation" regions. The model is then subjected to morphing techniques, where node locations are interpolated in the "interpolation" regions. The resulting model no longer exhibits damage. Instead, the model is smooth in the regions that previously exhibited damage.

Alignment of an integrally bladed rotor model requires in the airfoils being numbered in a consistent manner. The airfoil numbering process, however, may be ill-defined and not consistent across different manufacturing and production facilities. The disclosed embodiments alleviate these issues because they remove any dependency on the use of as-manufactured data. Further, by smoothing damage regions using the disclosed methodology, FE models may be subjected to existing morphing techniques for removing the damage virtually without the need for new morphing techniques. Creation of such techniques may be expensive and time consuming.

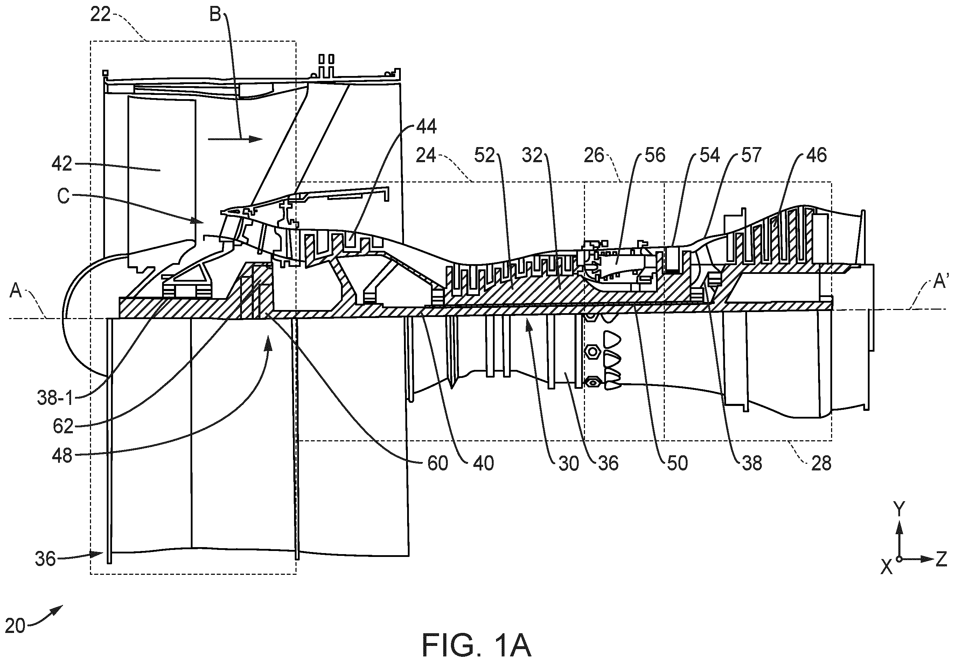

Figure 1A depicts a cross-sectional view of a gas-turbine engine 20 according to the disclosed embodiments. Gas-turbine engine 20 may be a two-spool turbofan that incorporates a fan section 22, a compressor section 24, a combustor section 26, and a turbine section 28. During operation, fan section 22 may drive air along a path of bypass airflow B while compressor section 24 can drive air along a core flow path C for compression and communication into combustor section 26 then expansion through turbine section 28.

Although depicted as a turbofan gas engine 20 herein, it may be understood that the concepts disclosed herein are not limited to use with turbofans as the teachings may be applied to other types of turbine engines including three-spool architectures, single spool architecture, and the like.

Gas turbine engine 20 may include a low speed spool 30 and a high speed spool 32 mounted for rotation about an engine central longitudinal axis A-A' relative to engine static structure 36 or engine case via several bearing systems 38, 38-1, and so on. Engine central longitudinal axis A-A' is oriented in the Z direction on the provides X-Y-X axes. It may be understood that various bearing systems 38 at various locations may alternatively or additionally be provided, including, for example, bearing system 38, bearing system 38-1, and so on.

Low speed spool 30 may include an inner shaft 40 that interconnects a fan 42, a low pressure compressor 44, and a low pressure turbine 46. Inner shaft 40 may be connected to fan 42 through a geared architecture 48 that can drive fan 42 at a lower speed than low speed spool 30. Geared architecture 48 may include a gear assembly 60 enclosed within a gear housing 62. Gear assembly 60 couples inner shaft 40 to a rotating fan structure. High speed spool 32 may include an outer shaft 50 that interconnects a high pressure compressor 52 and high pressure turbine 54.

A combustor 56 may be located between high pressure compressor 52 and high pressure turbine 54. A mid-turbine frame 57 of engine static structure 36 may be located generally between high pressure turbine 54 and low pressure turbine 46. Mid-turbine frame 57 may support one or more bearing systems 38 in turbine section 28. Inner shaft 40 and outer shaft 50 may be concentric and rotate via bearing systems 38 about the engine central longitudinal axis A-A', which is collinear with their longitudinal axes. In some embodiments, a "high pressure" compressor or turbine experiences a higher pressure than a corresponding "low pressure" compressor or turbine.

The core airflow may be compressed by low pressure compressor 44 then high pressure compressor 52, mixed and burned with fuel in combustor 56, then expanded over high pressure turbine 54 and low pressure turbine 46. Turbines 46 and 54 rotationally drive the respective low speed spool 30 and high speed spool 32 in response to the expansion.

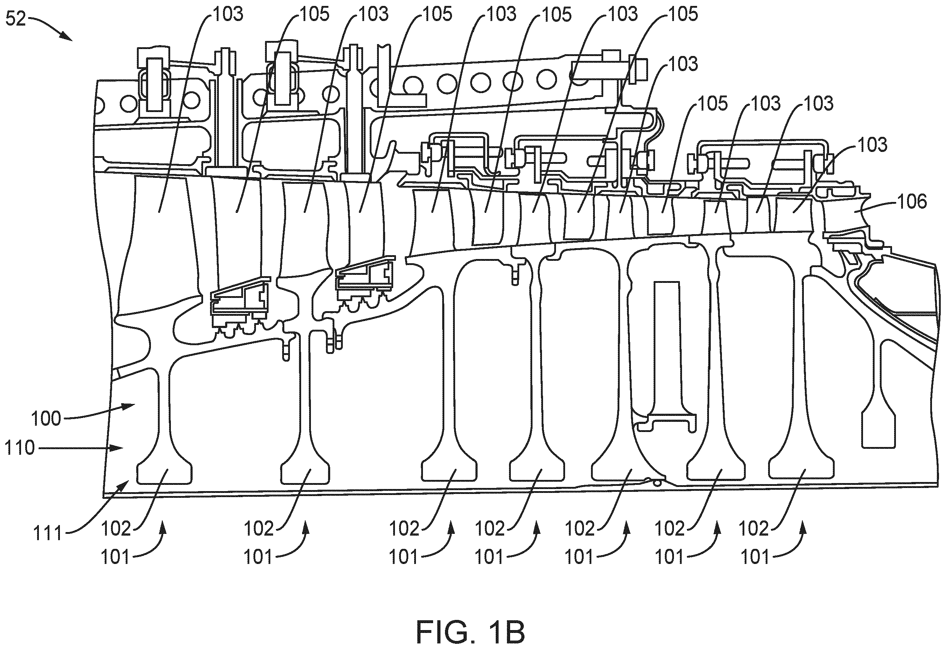

Figure 1B depicts a cross-sectional view of a high pressure compressor 52 according to the disclosed embodiments. High pressure compressor 52 of compressor section 24 of gas turbine engine 20 is provided. High pressure compressor 52 includes a plurality of blade stages 101, or rotor stages, and a plurality of vane stages 105, or stator stages. Blade stages 101 may each include an integrally bladed rotor (IBR) 100, such that blades 103 and rotor disks 102 are formed from a single integral component, or a monolithic component formed of a single piece. In some embodiments, the inspection, analysis, and repair systems disclosed herein may be utilized with bladed rotors formed of separate blades 103 and rotor disks 102.

Blades 103 extend radially outward from rotor disk 102. Gas turbine engine 20 may further include an exit guide vane stage 106 that defines the aft end of high pressure compressor 52. In some embodiments, low pressure compressor 44 may include a plurality of blade stages 101 and vane stages 105, each blade stage in the plurality of blade stages 101 including IBR 100. In other embodiments, the plurality of blade stages 101 form a stack of IBRs 110, which define, at least partially, a rotor module 111 of high pressure compressor 52 of gas turbine engine 20.

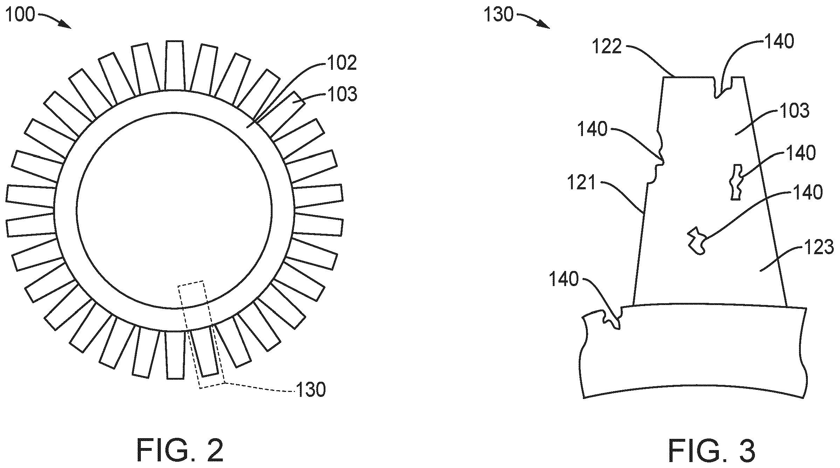

Figure 2 depicts a front view of an IBR 100 according to the disclosed embodiments. IBR 100 includes a rotor disk 102 and a plurality of blades 103 extending radially outward from rotor disk 102.

When debris is ingested into gas turbine engine 20, the debris may pass into the primary flowpath. Due to the rotation of blades 103 in the primary flowpath, the debris may contact one or more blades 103. This contact may cause damage or wear to a blade 103, or a set of blades 103. Thus, systems and methods are used for inspection, analysis, and repair of an IBR 100 to return the IBR back to service after inspection or repair. Portion 130 is shown for one of blades 103, and disclosed in greater detail by Figure 3.

Figure 3 depicts a damaged portion 130 of IBR 100 according to the disclosed embodiments. Damaged portion 130 includes a number of defects 140 resulting from use of IBR 100 in gas turbine engine 20 over time. Defects may be caused by damage, wear, debris, and the like. The size and shape of defects 140 may be exaggerated for illustrative purposes within Figure 3. In some embodiments, defects 140 may extend to all of blades 103 of IBR 100, rotor disk 102, a set of blades 103 of IBR 100, a single blade in blades 103, none of blades 103, and the like.

In order to repair one or all of defects 140, a blending operation may be performed on IBR 100. A blending operation may use a material removal process, such as milling or computer numerical control (CNC) machining, to remove the damaged portion of IBR 100 and smooth the resulting voids such that IBR 100 can be re-introduced into service for further use.

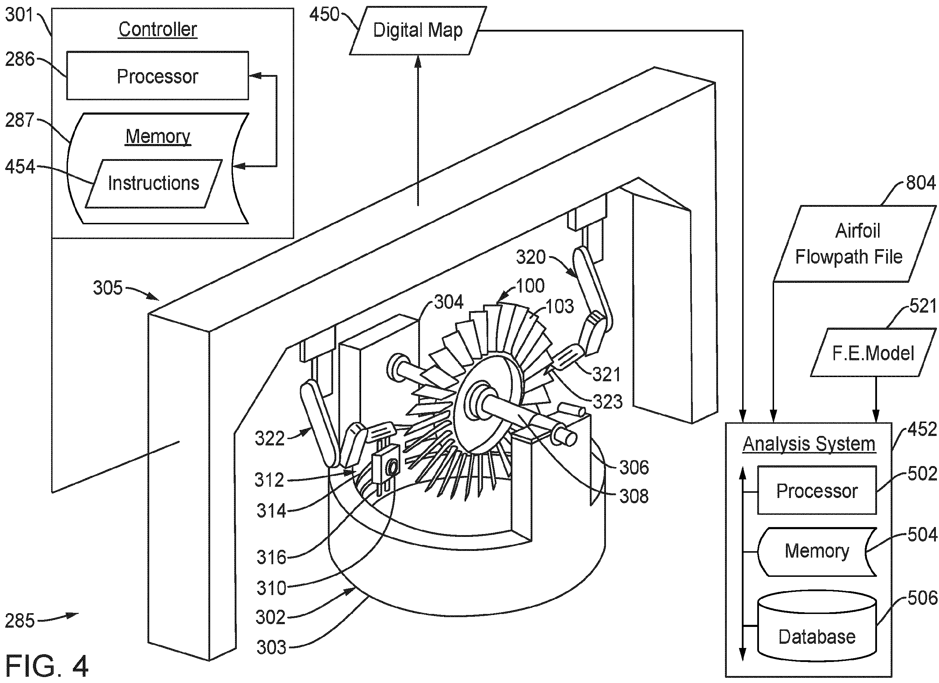

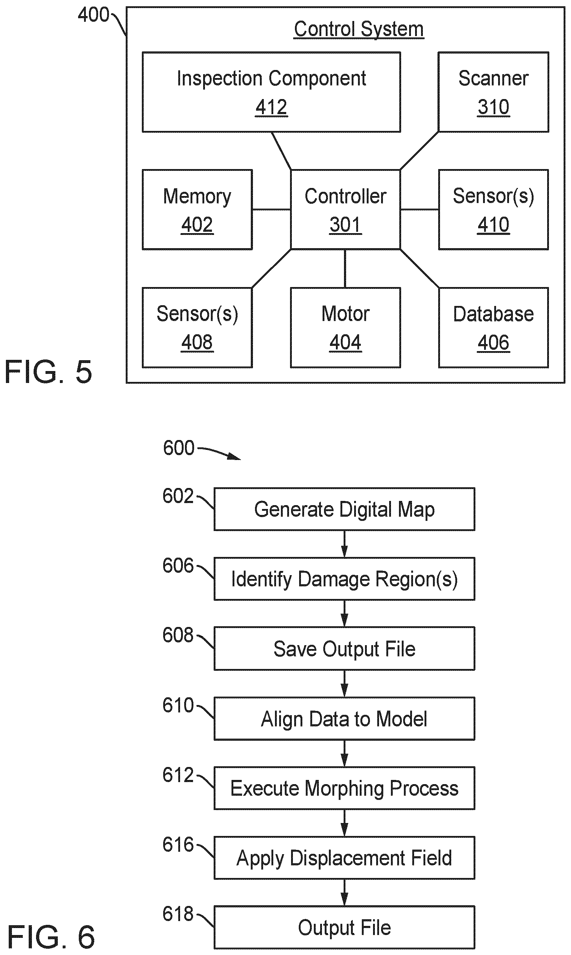

Reference is now made to Figures 4 and 5. Figure 4 depicts a perspective view of inspection system 285 analyzing an IBR 100 according to the disclosed embodiments. Figure 5 depicts a block diagram of a control system 400 for inspection system 285 according to the disclosed embodiments. In some embodiments, inspection system 285 may include a repair system that also is connected to control system 400 through controller 301. Various components of inspection system 285 may be configured to inspect IBR 100 and generate a digital map 450 of IBR 100, such as a point cloud. Inspection system 285 may be configured to transmit digital map 450 to an analysis system 452. Inspection system 285 may receive the results from analysis system 452 or perform a repair based on determination from analysis system 452, in accordance with various embodiments.

Inspection system 285 includes a controller 301, a support structure 302, a shaft 308, and a scanner 310. In some embodiments, control system 400 includes controller 301, scanner 310, a memory 402, a motor 404, a database 406, and sensor(s) 408, sensor(s) 410, and inspection component 412. In some embodiments, inspection system 285 includes a device 305 configured for bladed rotor repair or bladed rotor inspection.

Support structure 302 includes a base 303, a first vertical support 304, a second vertical support 306. Base 303 may be annular in shape. Base 303 may be any other shape. For example, base 303 may be semi-annular in shape, a flat plate, and the like. In some embodiments, vertical supports 304 and 306 extend vertically upward from base 303 on opposite sides of the base, such as 180 degrees apart, or opposite sides if base 303 is a square plate. Shaft 308 extends from first vertical support 304 to second vertical support 306. Shaft 308 may be rotatably coupled to motor 404, which may be disposed within first vertical support 304. Shaft 308 may be restrained vertically and horizontally at second vertical support 306 but free to rotate relative to the second vertical support about a central longitudinal axis of shaft 308. In some embodiments, a bearing assembly may be coupled to second vertical support 306 to facilitate rotation of shaft.

In some embodiments, IBR 100 to be inspected may be coupled to shaft 308. Scanner 310 is operably coupled to a track system 312. Track system 312 may include a curved track 314 and a vertical track 316. Vertical track 316 may slidingly couple to curved track 314, via rollers and the like. Scanner 310 may be slidingly coupled to vertical track 316, such as using a conveyor belt, linkages, and the like. Scanner 310 may be configured to extend from track system 312 towards IBR 100 during inspection of the IBR by inspection system 285.

Inspection system 285 also may include a control arm 322, such as a robot arm, an actuator in combination with track system 312, and the like. Tracks 314 and 316, control arm 322, and an actuator of track system 312 may be implemented to move components within inspection system 285. In alternate embodiments, any electronically controlled, such as a wireless or wired, component may be configured to move scanner 310, a machining tool, such as a mill, a cutter, a lathe, and the like, or other component in six degrees of freedom relative to IBR 100.

Inspection component 412 of control system 400 includes rollers for the curved track, a conveyor belt for the vertical track, or a robotic arm coupled to scanner 310. Inspection component 412 also may include a control arm 322. In some embodiments, inspection component 412 is stationary and IBR 100 is moved along a three-axis, a five-axis, and the like coordinate system.

Scanner 310 includes a coordinate measuring machine (CMM), a mechanical scanner, a laser scanner, a structured scanner, such as a white light scanner, a blue light scanner, and the like, a non-structured optical scanner, a non-visual scanner, and the like. For example, scanner 310 may be a blue light scanner. A "blue light scanner" may refer to a non-contact structure light scanner. The blue light scanner may have a scan range of between 100 x 75 mm² to 400 x 300 mm². An accuracy of the blue light scanner may be between 0.005 and 0.015 mm. The blue light scanner may determine distances between adjacent points in the point cloud of between 0.04 and 0.16 mm as measured across three axes. In some embodiments, a volume accuracy of the blue light scanner may be approximately 0.8 mm/m. A scan depth may be between approximately 400 and 450 nm. These parameters are illustrative only and may be outside these ranges. Use of a blue light scanner provides a high resolution point cloud for a three-dimensional object as digital map 450.

Inspection system 285 also may include a control arm 320. Control arm 320 may include a tool holder 321. Tool holder 321 is configured to couple to a subtractive component 323, such as a mill, a lathe, a cutter, and the like. Control arm 322 of inspection system 285 may be used for repair operations. Inspection system 285 may utilize control arm 320 along with control arm 322 for inspection and repair operations.

Controller 301 may be integrated into inspection system 285, using processor 286 and memory 287. Controller 301 may be configured as a central network element or hub to various systems and components of control system 400. Controller 301 includes processor 286, which is coupled to memory 287. Processor 286 executes instructions 454 stored in memory 287 to configure inspection system 285 and control system 400 to perform the functions disclosed herein. Controller 301 may be implemented as a single controller, such as through a single processor 286 and associated memory 287. Controller 301 also may be implemented as multiple processors, such as a main processor and local processors for various components. Controller 301 may be a general purpose processor, a digital signal processor (DSP), an application specific integrated circuit (ASIC), a field programmable gate array (FPGA), or other programmable logic device, discrete gate or transistor logic, discrete hardware components, or any combination thereof. Controller 301 may include a processor configured to implement various logical operations in response to the execution of instructions 454.

Motor 404 of control system 400 is operably coupled to shaft 308 of inspection system 285. Motor 404 may comprise a direct current (DC) stepper, an alternating current (AC) motor, and the like. Sensor(s) 408 may include Hall effect sensor(s), optical sensor(s), resolver(s), and the like. Sensors 408 may include sensors configured to detect an angular position of shaft 308 during an inspection step for IBR 100. During inspection of IBR 100, controller 301 receives sensor data from sensors 408. Controller 301 may utilize the sensor data received from sensors 408 to correlate an angular position of IBR 100 being inspected with a location of scanner 310. In some embodiments, IBR 100 may remain stationary throughout an inspection process, such that control arm 320 or control arm 322 moves. Coordinates of the control arms may be determined via sensors 408 in a similar manner to orient and construct IBR 100 being inspected.

Sensor(s) 410 are configured to detect a position of scanner 310 during inspection processes. In this regard, sensors 410 may be position sensors, such as capacitive displacement sensors, eddy-current sensors, Hall effect sensors, inductive sensors, optical sensors, linear variable differential transformer (LVDT) sensors, photodiode array sensors, piezo-electric sensors, encoders, potentiometer sensors, ultrasonic sensors, and the like. During inspection of IBR 100, controller 301 is able to determine a location of scanner 310, an angular location of IBR 100 throughout the inspection. Based on the location of scanner 310, an angular location of IBR 100 and scanning data received from scanner 310, a digital map 450, or a robust point cloud, may be generated during the inspection of IBR 100. The point cloud encompasses the entire IBR, such as 95% to 100% of a surface area of IBR 100.

Analysis system 452 may be used for inspection, analysis, and repair processes for IBR 100. Analysis system includes processor 502, memory 504, and database 506. In some embodiments, analysis system 452 is a computer-based system. In other embodiments, analysis system 452 is a cloud-based computing system. Processor 502 is configured to receive digital map 450 from inspection system 285 via control system 400. Digital map 450 includes a point cloud or three-dimensional model of IBR 100.

Thus, defects 140 of IBR 100, as shown in Figure 3, may be graphically depicted in finite element model 521. In some scenarios, finite element model 521 having defects 140 may cause issues with running structural or other simulations. The finite element model 521 is a modification of an original finite element model that reflects the specific damage or wear present on IBR 100.

Figure 6 depicts a flowchart 600 for removing damage detected on a scan of an IBR 100 from an output file for a model according to the disclosed embodiments. Flowchart 600 may refer to Figures 1A-5 for illustrative purposes. Flowchart 600, however, is not limited to the embodiments disclosed by Figures 1A-5. The embodiments disclosed by flowchart 600 remove damage to a scanned blade, or airfoil, before being used in a finite element model analysis. The processes disclosed herein smooth regions of the model where damage exists. Such a model may be desired so that blend repairs may be analyzed on a blade or the IBR. In some embodiments, analysis system 452 may execute the processes disclosed by flowchart 600 to provide a revised finite element model 521 not having defects 140.

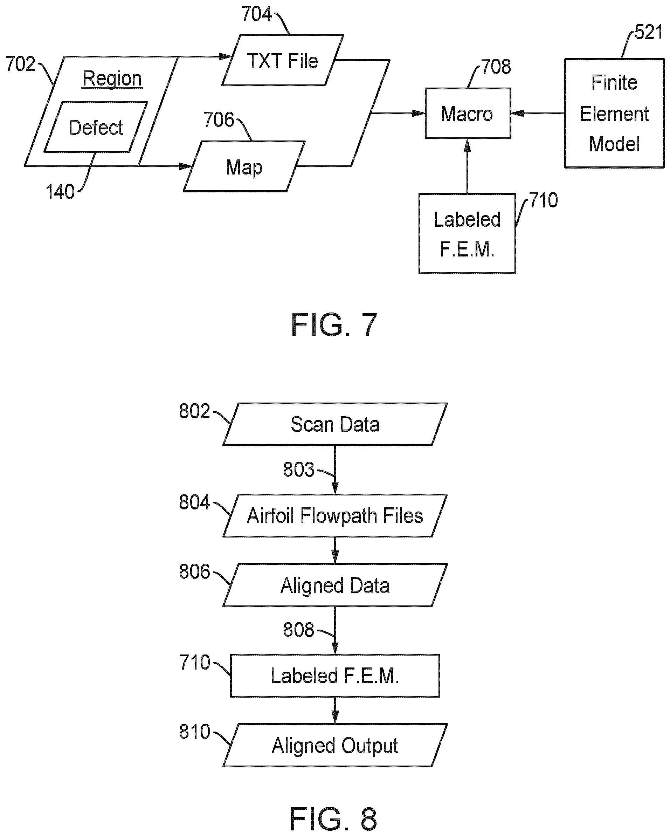

Step 602 executes by generating a digital map 450 of IBR 100 using inspection system 285. This process is disclosed above. Digital map 450 also may be referred to as scan data. A finite element model 521 may be provided from another source outside inspection system 285 and analysis system 452. Likewise, airfoil flowpath files 804 may be provided from another source outside inspection system 285 and analysis system 452. Airfoil flowpath files 804 are disclosed in greater detail below within Figure 8.

Step 606 executes by identifying at least one region within the scan data of digital map 450 as having damage, such as defects 140 disclosed above. The disclosed embodiments format the damage, or defects 140, for reading into the process of generating an interpolation region into a new component in the finite element model. The reported damage may use consistent naming across IBRs subject to inspection by inspection system 285. Each finite element model 521 may not have the same names for these defects so a map may be used in identifying the regions and defects. This process formats the scan data for the identified region into a .txt file.

This process is disclosed in greater detail by Figure 7, which depicts a block diagram of the identification of damage regions in a scan file according to the disclosed embodiments. Region 702 having defect 140 is identified within digital map 450, or the scan data. Regions not having any damage are ignored. Defect 140 is formatted for reading into macro 708 within TXT file 704. Further, map 706 is created for consistent naming within inspection system 285 or analysis system 452. For example, damage on the leading edge of a blade 103 would map to the leading edge nodes component of finite element model 521.

Macro, or computer code, 708 is run with TXT file 704 and finite element model 521. Macro 708 may define a pattern of how an input is mapped to a replacement output. Here, TXT file 704, finite element model 521, and map 706 may be the input. A finite element analysis and modeling simulation software job may be launched that runs macro 708. Macro 708 generates labeled finite element model 710. A labeled finite element model file may refer to a constant database file. A constant database file may provide perform as an associative array (on-disk), mapping keys to values, which enables multiple values to be stored in a single key. Labeled finite element model 710 includes the nominal geometry and new "interpolation" component defining the nodes in damage, or defect, region 702.

Step 608 executes by storing the output file. Labeled finite element model 710 may be stored for later use within flowchart 600. It should be noted that defined damage region 702 may not match scan data within digital map 450 precisely. Labeled finite element model 710 provides the bridge between both sets of data. Labeled finite element model 710 has a role in the morphing process disclosed below because morphing in the "interpolation" region will be interpolated, thereby making it smooth, instead of matched to the scan, where there are discontinuities.

Step 610 executes by aligning the scan data of digital map 450 to airfoil, or IBR 100, flowpath files. This aligned data is then aligned to labeled finite element model 710. The different data files will be in different locations in space. The data should be aligned in the same location. Reference may be made to Figure 8, which depicts a block diagram of the alignment process according to the disclosed embodiments.

Scan data 802, airfoil flowpath files 804, and finite element model 521 may be loaded to analysis system 452. Scan data 802 may be the scan data of digital map 450 generated from inspection system 285. Scan data 802 goes through an alignment process 803 with a nominal file of airfoil flowpath files 804. Airfoil flowpath files may be CAD model files that correspond to blades 103 of IBR 100. Alignment process 803 generates aligned data 806 of scan data 802 and an airfoil flowpath (CAD model) file for a blade 103 of IBR 100. Rotations and translations may be performed to align the data sets.

An alignment process 808 is executed to further align aligned data 806 with labeled finite element model 710. Scan data 802 and airfoil flowpath file 804 is moved to labeled finite element model 710. The rotations and translations applied above also may be further configured for alignment on labeled finite element model 710. The result is aligned output 810, which may be a file having the different sets of data (scan data 802, airfoil flowpath file 804, and labeled finite element model 710) as aligned. Alternatively, aligned output 810 may be labeled finite element model 710 with aligned data 806 therein.

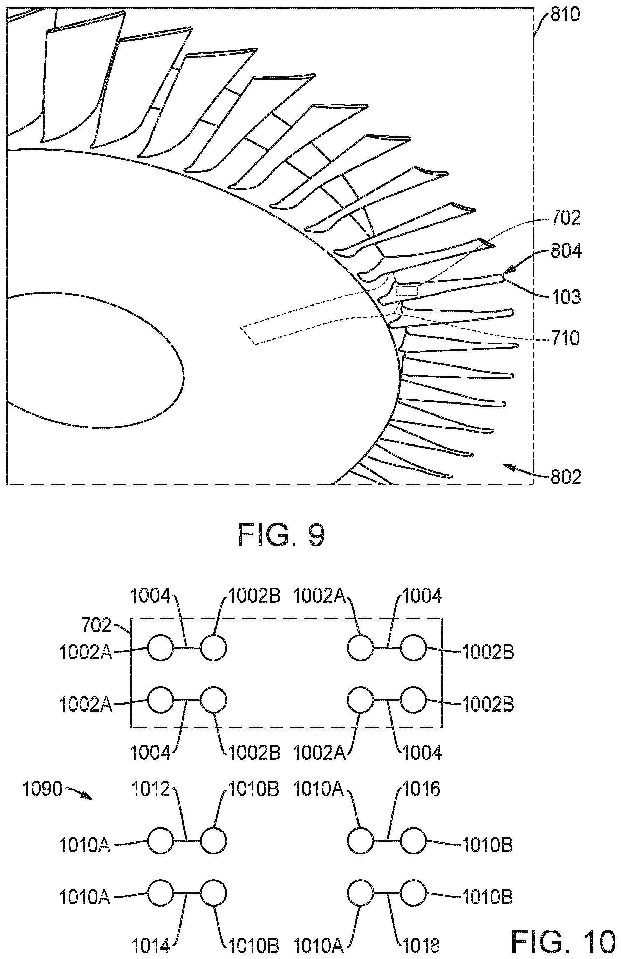

Figure 9 depicts an example of an aligned output 810 according to the disclosed embodiments. As may be appreciated, scan data 802 of IBR 100 is provided and aligned with labeled finite element model 710 of region 702 having a defect 140 on a blade 103. This region may be defined within labeled finite element model 710. Airfoil flowpath file 804 for blade 103 is aligned with region 702 as well. In some embodiments, region 702 may be smaller than an entire blade 103. Region 702 may only include the portion of blade 103 having defect 140. Further, other files may be aligned with scan data 802 and labeled finite element model 710.

Returning to Figure 6 and flowchart 600, step 612 executes by executing a morphing process within the plurality of regions of the entire blade, including region 702 having defect 140. Initially, labeled finite element model 710 is morphed to match scan data 802 with the exception of the identified regions having damage, such as region 702 with defect 140. Labeled finite element model 710 may be finite element model 521 with the damaged regions identified. The damaged regions are "interpolation" regions for this operation. For example, region 702 does not move with the morphing process for this feature.

Morphing for region 702 occurs separate from the initial morphing operations. Within labeled finite element model 710, region 702 having defect 140 may include nodes. These nodes are kept the same within during the initial morphing operation with CDB file 710 and scan data 802. Nodes outside region 702, however, are moved. These nodes outside region 702 within labeled finite element model 710 may be move a distance during the initial morphing operation. An average distance for this movement is determined. The average distance is then applied to move the nodes within region 702 that were not moved. Thus, the nodes within region 702 may be interpolated using these operations.

Figure 10 depicts nodes within region 702 having defect 140 and nodes outside region 702 within labeled finite element model 710 according to the disclosed embodiments. Figure 10 may disclose an example interpolation process for the nodes within region 702. Nodes 1002A correspond to the nodes within region 702 before any movement is performed using the displacement field, or interpolation. The disclosed embodiments, instead, determines movement of nodes 1010A within region 1090 of labeled finite element model 710. Region 1090 does not include any damage or defects 140.

Nodes 1010A are displaced during the morphing of CDB file 710 to scan data 802 of digital map 450 for IBR 100. Displaced nodes 1010B may result. A distance may be determined between original node 1010A and displaced node 1010B. For example, region 1090 includes four original nodes 1010A and four displaced nodes 1010B. The distance between each of these may differ. Thus, distances 1012, 1014, 1016, and 1018 vary within space.

The average of distances 1012, 1014, 1016, and 1018 is determined for the displacement of nodes within region 1090. This average is used to displace nodes 1002A within region 702. Average distance 1004 is used to move nodes 1002A in a direction and distance corresponding to the movement of nodes 1010A. Thus, displaced nodes 1002B may be determined for region 702 using average distance 1004.

The nodes that moved inside and outside region 702 are then applied to the corresponding airfoil flowpath model 804 to represent the movement of the nodes. This movement then morphs region 702 to also resemble those portions of the aligned data that was not damaged. Airfoil flowpath file 804 for the aligned blade is smoothed using the movement of the nodes within the region.

Referring to Figure 6 and flowchart 600, step 616 executes by applying the displacement field to the plurality of regions. The disclosed embodiments apply the displacement field defined by the morphing process. The displacement field is applied to airfoil flowpath file 804 aligned with the region or regions within labeled finite element model 710. The disclosed embodiments determine each portion of labeled finite element model 710 that moved and applied these portions to the aligned airfoil flowpath file.

Further, step 616 may include moving the smoothed airfoil flowpath file back to its original position. In other words, aligned data 806 is undone. The operations to align airfoil flowpath file 804 to labeled finite element model 710 include translations and rotations. Thus, region 702 is "morphed" to remove the scan data showing defect 140. For example, if a model needed to rotate 90 degrees in the negative x-direction and translate 120 centimeters in the positive y-direction in order to align the models, then those movements need to be reversed to place the model back in its original design space. From the aligned position, the model will undergo a translation of 120 centimeters in the negative y-direction and a rotation of 90 degrees in the positive x-direction.

Step 618 executes by outputting labeled finite element model 710 along with the damage removed in region 702. The outputted model then may be used as a finite element model in simulations for blade 103, but without the damage or defects captured by inspection system 285.

As will be appreciated by one skilled in the art, the present invention may be embodied as a system, method or computer program product. Accordingly, the present invention may take the form of an entirely hardware embodiment, an entirely software embodiment (including firmware, resident software, micro-code, etc.) or an embodiment combining software and hardware aspects that may all generally be referred to herein as a "circuit," "module," or "system." Furthermore, the present invention may take the form of a computer program product embodied in any tangible medium of expression having computer-usable program code embodied in the medium.

The corresponding structures, material, acts, and equivalents of all means or steps plus function elements in the claims below are intended to include any structure, material or act for performing the function in combination with other claimed elements are specifically claimed. The description of the present invention has been presented for purposes of illustration and description, but is not intended to be exhaustive or limited to the invention in the form disclosed. Many modifications and variations will be apparent to those of ordinary skill without departing from the scope of the invention. The embodiment was chosen and described in order to best explain the principles of the invention and the practical application, and to enable others of ordinary skill in the art to understand the invention for embodiments with various modifications as are suited to the particular use contemplated.

Modifications and equivalents may be made to the features of the described embodiments without departing from the scope of the invention as defined in the appended claims.

## Claims

1. A method comprising:
generating a digital representation of a component, wherein the digital representation is based on geometrical dimensions of the component;
identifying at least one region of a plurality of regions within the digital representation of the component as showing damage to the component, wherein the at least one region includes a boundary;
executing a morphing process within the plurality of regions of the digital representation;
applying a displacement field on the plurality of regions; and
generating an output file having the damage removed within the at least one region of the digital representation.

2. The method of claim 1, further comprising interpolating based on a node location within the at least one region; and, optionally,
wherein executing the morphing process includes executing the morphing process based on the node location.

3. The method of claim 1 or 2, wherein the identified at least one region is marked as an interpolation region for an inspection process using the digital representation.

4. The method of any preceding claim, further comprising smoothing the at least one region of the digital representation using the morphing process.

5. The method of any preceding claim, further comprising scanning the component into a surface geometry model as the digital representation.

6. The method of any preceding claim, further comprising generating a new digital representation of the component prior to the damage.

7. The method of any preceding claim, wherein the component is a blade of a bladed rotor.

8. The method of any preceding claim, wherein executing the morphing process includes generating a sequence of intermediate images for the at least one region within the boundary; and, optionally,
further comprising applying the sequence of intermediate images to the at least one region to remove the damage identified in the digital representation.

9. A method comprising:
generating a digital representation of a blade of a bladed rotor having damage, wherein the digital representation is based on geometrical dimensions of the component;
marking a boundary around the damage to the blade within the digital representation;
identifying a region based on the boundary within the digital representation of the blade showing the damage;
interpolating based on a node location within the boundary of the region;
executing a morphing process within the plurality of regions of the digital representation;
applying a displacement field on the plurality of regions; and
generating a new digital representation of the blade having the damage removed.

10. The method of claim 9, wherein the region is marked as an interpolation region for an inspection process using the digital representation.

11. The method of claim 9 or 10, further comprising smoothing the region within the boundary on the digital representation using the morphing process; and/or
further comprising scanning the component into a surface geometry model as the digital representation.

12. An article of manufacture including a tangible, non-transitory computer-readable storage medium having instructions stored thereon that, in response to execution by a processor, configures the processor to perform operations comprising:
generating a digital representation of a component, wherein the digital representation is based on geometrical dimensions of the component;
identifying at least one region of a plurality of regions within the digital representation of the component as showing damage to the component, wherein the at least one region includes a boundary;
executing a morphing process within the plurality of regions of the digital representation;
applying a displacement field on the plurality of regions; and
generating an output file having the damage removed within the at least one region of the digital representation.

13. The article of manufacture of claim 12, wherein the operations further comprise interpolating based on a node location within the at least one region.

14. The article of manufacture of claim 13, wherein executing the morphing process includes executing the morphing process based on the node location.

15. The article of manufacture of claim 14, wherein the operations further comprise smoothing the at least one region of the digital representation using the morphing process; and/or
wherein the operations further comprise scanning the component into a surface geometry model as the digital representation; and/or
wherein the component is a blade of a bladed rotor.
